# EUROPEAN PATENT SPECIFICATION

(11) **EP 3 071 529 B1**
(45) Date of publication and mention of the grant of the patent: **26.09.2018**
(21) Application number: 14803192.5
(22) Date of filing: 19.11.2014
(51) Int. Cl.: C03C 17/00, C23C 16/455, C23C 16/52, C23C 16/54

(54) **COATING APPARATUS**
BESCHICHTUNGSVORRICHTUNG
APPAREIL DE REVÊTEMENT

(30) Priority: 20.11.2013 GB 201320521
(43) Date of publication of application: 28.09.2016
(73) Proprietor: Pilkington Group Limited, Nr. Ormskirk, Lancashire L40 5UF (GB)
(72) Inventor: SANDERSON, Kevin David, Skelmersdale Lancashire WN8 0BQ (GB); WILLIAMS, Ian Ross, Wigan Lancashire WN8 7DJ (GB); NELSON, Douglas Martin, Curtice, Ohio 43412 (US)
(74) Representative: Hazzard, Alan David
(86) International application number: PCT/GB2014/053406
(87) International publication number: WO 2015/075434

(56) References cited:
- WO-A1-96/33955
- US-A- 4 389 234

## Description

The invention is concerned with methods and apparatus for deposition of coatings on glass articles, particularly glass vessels such a bottles and jars, during a continuous manufacturing process.

There are numerous situations, where it is desirable or convenient to deposit coatings on glass vessels. For example, during manufacture of glass bottles, a coating of tin oxide is frequently applied to the bottle at the so-called 'hot end' of the process i.e. when recently cast bottle still retains a significant amount of heat. This coating serves a number of purposes.

The coating reduces the degree of 'scuffing' (i.e. visible surface damage having an adverse aesthetic effect) during subsequent process steps. The coating also provides good adhesion for a subsequent polymer coating that is deposited at the 'cold end' of the process for additional lubrication. The coating also improves the strength of the bottle.

A number of approaches have been adopted in the past, to the task of depositing coatings on glass articles.

WO2006/009872 describes deposition by direct injection Chemical Vapour Deposition (CVD) wherein CVD precursors are dissolved in a solvent comprising an ionic liquid which is then injected into a packed vaporiser having a counter current carrier gas flow. The carrier gas strips the precursors from the solvent and transports them in the vapour phase to a deposition chamber where the coating is formed by conventional CVD methods.

More recently, WO2013/163 005 describes a coating apparatus in which a compound to be deposited (a metal oxide) is injected into an air stream which is directed over the article to be coated.

The deposition of coatings on flat glass by CVD methods is well know. Conveniently this is done during the float glass manufacturing process where residual heat from said process assists in the reaction of precursors, which are brought to the surface of the hot glass ribbon that is produced during the float glass process. CVD done on float glass in this way is done at atmospheric pressure - APCVD

The precursors may be brought to their reaction site separately, i.e. each precursor is brought to the surface of the glass via its own dedicated conduit, only to mix with other precursors on reaching the vicinity of the glass surface but there are certain advantages to 'pre-mixing' systems (in terms of the relative simplicity of the apparatus) in which the precursors are mixed before delivery to the reaction site.

A number of coating apparatuses exist for articles such as bottles, which comprise a coating tunnel having side walls and a top, the tunnel being conveniently located on a conveyor belt which transports the bottles through the tunnel.

The sidewalls of the tunnel include apertures, typically slots through which coating materials are delivered, typically in a carrier gas. Exhaust apertures are also typically included.

As the bottles are transported through the tunnel they pass the slots and coating materials are delivered to the surface of the bottle.

In some instances, manufacturers choose to avoid coating of a particular region of an article. For example, where a coating is applied to bottles for beer or carbonated drinks, manufacturers may choose to avoid coating of the lip of the bottle as some coatings may provide a surface roughness or nucleation points which cause unwanted effervescence as the liquid is poured.

EP0519597 describes glass coating apparatus and methods of the type referred to above. In this case a non-turbulent air supply is directed downwards across the coating material stream in order to prevent coating in the top region (particularly the lip) of the bottle. WO02066389 describes a bottle coating apparatus comprising a coating tunnel in which slots are provided for supplying and exhausting coating materials in gas mixture. In this case, the slots are horizontal and spaced apart so that only strips of the bottle, corresponding to the areas which contact their neighbours during processing, are coated. This patent also describes dual coating of the bottles by applying a first coating (e.g. tin oxide) whose deposition is assisted by residual heat in the bottles after casting from the molten state (a so called 'hot end' coating) and a second coating (e.g. a polymer spray coating) which is applied at a point in the production process where the bottles have significantly cooled (a 'cold end' coating).

One problem which arises in continuous process coaters of the type described above, is that the arrangement of inlet apertures and flow paths gives rise to a high degree of vorticity and shear in the carrier gas streams. This in turn gives rise to uneven coating as the unstable jets sometimes briefly flick over articles such as bottles while at other times remain directed at one area.

Moreover, for three-dimensional object such as a bottle, the distance from the object to the coating slots (and exhaust vents) is not constant along the height of the object. For example, the body surface of a bottle is closer to the slot than the surface of the narrower neck. This gives rise to uneven coatings when produced by apparatus such as WO02066389.

Lastly, this type of apparatus allows ambient air to enter the tunnel via the ends and this air contains a certain level of contaminants such as moisture which can affect the coating process. Moisture may also be introduced to the interior of the tunnel via a finishing gas stream used to purge the top region of the bottles as described previously.

WO 96/33955 A1 describes coating apparatuses for coating three dimensional glass articles.

While these prior art coating apparatuses serve many purposes, where uniformity, surface texture etc of coatings may not be crucial, new applications for coatings are frequently emerging which require greater control over thickness, uniformity surface texture and other qualities.

According to the invention, apparatus for coating three dimensional glass articles comprises the features set out in claim 1 attached hereto.

In a preferred embodiment, the means for providing a curtain of flowing gas comprises at least one linear inlet aperture arranged on a sidewall, each such aperture being connected to a source of compressed gas and a linear exhaust aperture is arranged on the opposite sidewall to the linear inlet aperture and aligned therewith, the linear exhaust aperture being connected to means for applying a negative pressure thereto.

The curtain of flowing gas may conveniently be arranged to traverse the path of the articles between one or more nozzles delivering a first set of chemicals and one or more nozzles delivering a second set of chemicals.

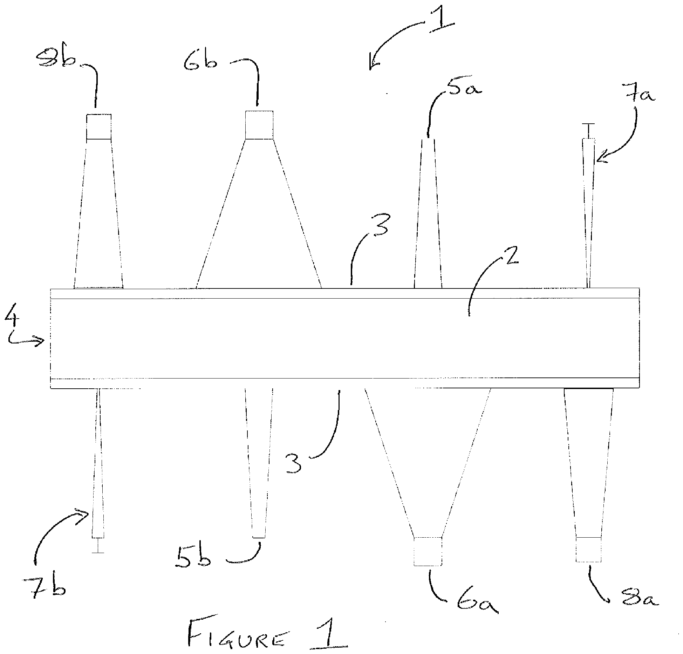

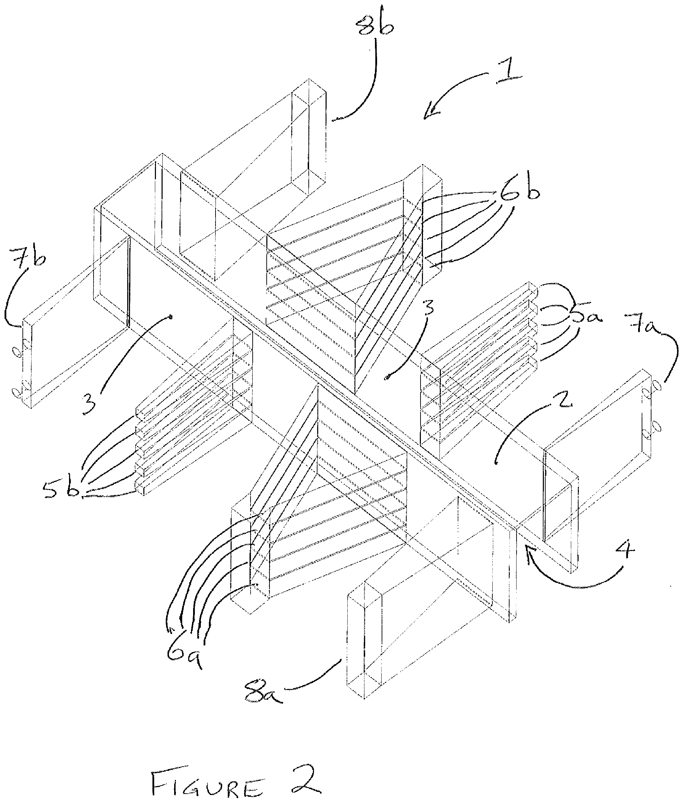

The invention will now be described, by way of non-limiting example, with reference to the following figures in which figures 1 and 2 show respectively plan and perspective views of coating apparatus according to the invention.

Referring to the figures, apparatus for coating glass articles, according to the invention, comprises a hood 1 having a top 2 and sidewalls 3 defining a tunnel 4 through which the articles are conveyed by a conveyor belt (not shown).

Provided in at least one sidewall is a linear array of inlet nozzles 5a, which are preferably arranged vertically, or substantially orthogonal to the direction in which the articles travel. Provided in the sidewall opposite the nozzles 5a is at least one exhaust aperture 6a. In the preferred embodiment illustrated, a linear array of exhaust apertures 6a lead to an exhaust-chamber (not shown) that is maintained at a negative pressure. Alternatively, the exhaust aperture or apertures may take the form of a plate with a linear array of holes forming a plenum, such that the total area of the exhaust holes is no more than the cross-sectional area of the exhaust-chamber, thereby producing a controlled distribution of suction along the vertical length of the exhaust. The exhaust apertures can also include horizontal baffle plates to guide the exhausting jets and so improve the coating-flow stability. The negative pressure is conveniently applied by an extractor fan (not shown).The nozzles 5a are each connected to an independently variable supply of gas (not shown). Typically this would be carrier gas mixed with coating material or coating precursors (e.g. chemical precursors for coating by CVD) but one or more nozzle might supply a purge gas directed to a particular region of the articles. This would avoid coating on that region. For example, it may be desirable to avoid coating the very top or lip of a bottle, so the uppermost nozzle in an array might deliver purge gas only. Suitable purge gases include air or nitrogen, of sufficient purity to avoid contamination of the reaction with moisture or other materials.

During operation, the nozzles 5a supply in concert a continuous jet of carrier gas/purge gas which traverses the path of the articles as they are conveyed through the tunnel and exits through the opposing exit apertures 6a. As the articles are conveyed through the tunnel, they pass through the jet and the coating is deposited. In the preferred embodiment illustrated, the nozzles are substantially rectangular.

For articles such as bottles, which typically require an 'all round' coating, a second arrangement of nozzles 5b and exhaust apertures 6b is provided. These are located on the opposite wall from nozzles 5a and exhaust apertures 6a respectively.

Since the nozzles 5a, 5b are independently variable it is possible to vary and control the coating deposition rate along the height of the article. Thus, regions which require a thicker coating (e.g. regions such as the shoulder or heel of a bottle, which are more likely to contact neighbouring bottles during processing and transit) may be treated accordingly.

Alternatively, the nozzle serving narrower region of the article, for example the neck of a bottle, may adjusted relative to the other nozzles, to take account of the greater distance between nozzle and glass in this region.

In some circumstances, it may be desirable to vary each nozzle independently, in terms of the flow rate that it delivers. However, such variation between nozzles in an array can give rise to shear between the streams delivered by each nozzle. In order to achieve a uniform jet across the height of the article, it may be preferable to maintain equal flow rates from all nozzles in an array.

In such cases, where variable deposition rate is required across the height of the article, or varying distance between nozzle and glass surface needs to be accounted for, it may be preferable to maintain equal flow rates at all nozzles in an array and to vary the concentration of coating material or precursors between nozzles in an array.

In the preferred embodiment illustrated by the figures, at least one linear inlet aperture 7a, 7b is provided which is connected to a supply of purge gas. Each of these is aligned with a linear exhaust aperture 8a, 8b to which a negative pressure is applied. During operation, each linear inlet aperture 7a, 7b provides a relatively narrow, substantially planar curtain of flowing gas which exits the corresponding linear exhaust aperture 8a, 8b.

These flowing gas curtains serve a number of purposes. First, they allow the coating region within the tunnel to be provided with a controlled atmosphere and prevent ambient air and airborne contaminants such as moisture from entering the tunnel via the ends.

Second, they allow multiple hot end coatings to be applied. By locating the gas curtain between one or more nozzles delivering a first set of chemicals (a first coating material or precursors thereof) and one or more nozzles delivering a second set of chemicals (a second coating material or chemical precursors thereof) the a dual or multiple hot end coating facility is provided where the gas curtain helps to ensure there is no cross-contamination between the coating reactions.

By placing tunnels such as that illustrated in figures 1 and 2 on the conveyor belt, end to end. Multiple coatings may be applied to glass articles in a single, continuous process with economy of space.

It should be noted that, while the means for providing one or more gas curtains are illustrated here in an embodiment which includes the linear array of nozzles 5a, 5b and exhaust apertures 6a, 6b, the feature of a gas curtain offers the above benefits in any apparatus where it is desirable to isolate the region in which the coating is deposited, and need not be used in combination with a particular type of inlet/outlet aperture for the carrier or other gases.

A variety of dual coating combinations offer desirable qualities for coated articles such as glass.

For example, sodium ions leaching from the glass ('alkali leaching') can have an adverse effect of film growth, particularly for hot-end CVD reactions which use metal halide precursors (e.g. monobutyltin trichloride). Without being bound by theory, it is believed that the sodium reacts with the halide to form a water soluble salt and subsequent washing causes this to dissolve. The coating is thus undermined and weakened.

These problems of alkali leaching may be mitigated by depositing a dense silica coating before the metal oxide or other subsequent coating. This prevents or reduces the extent of sodium ion migration to the coated surface.

Suitable chemical precursors for CVD deposition of silica a coating include silane, Di-T-Butoxydiacetoxysilane, SiCl₄, tetraethyl orthosilicate.

Suitable chemical precursors for the metal oxide coating include monobutyltin trichloride, dimethyl tin, SnCl₄, TiCl₄, and titanium alkoxides.

Optimisation of precursor concentrations and other reaction parameters necessary to achieve useful coatings is a routine operation within the abilities of a skilled person.

The dimensions of nozzles 5a, 5b; exhaust apertures 6a, 6b; linear apertures along with the flow rates, and spacing between adjacent items are selected to avoid interference between adjacent jets. Selection of these parameters is a matter of routine optimisation by experimentation or mathematical modelling and is within the abilities of a person skilled in the art. Nevertheless the following example data are provided.

It is found that nozzles having a width of 70% or more of the width the articles being coated have served well. For example, nozzles having an aperture of 56x56mm have served adequately with standard glass bottles having a diameter of about 70mm. These nozzles were formed in 2mm steel.

Ideally, the apparatus is dimensioned so as to produce a jet which is about double the width of the article at contacts. A larger jet allows for coating fluctuations to be averaged out over the article surface and a narrow jet may move around a round article such as a bottle in a chaotic fashion, 'flicking' between two sides.

The coating-gas flow speed exiting the nozzle is preferably several times greater than the line speed of the articles, for example more than 5 times, but in a more preferred embodiment a coating gas flow speed of 2 to 3 m/s was used on articles having a lines speed of 0.3m/s (i.e. up to 10 times greater). For the 56 x 56mm nozzles, this gives a gas flow rate of approximately 34m³/hour per nozzle.

Where the coating chemistry uses precursors that at too expensive for such flow rates, or the gas flow rate may be too high for some other reason, it is preferable to reduce the size of the nozzle apertures. For example, reducing the above nozzles by half, along the direction of travel of the bottles would give a 28 x 56mm aperture, reducing the total flow while maintain the same height.

For conditions given above, each liner array should be spaced apart from any adjacent exhaust apertures or air curtains by at least 200mm and preferably by 300mm. If the spacing is less than this, then counter flowing jets may interact leading to jet instability and some of the incoming precursor may be exhausted via the adjacent exhaust apertures.

## Claims

1. Apparatus for coating three dimensional glass articles comprising:
a tunnel, having a top and first and second sidewalls, suitable for arranging on a conveyor belt which transports the articles through said tunnel;
one or more nozzles arranged to deliver a gaseous mixture comprising a first set of chemicals including one or more first coating materials or precursors thereof, in a jet which traverses the path of the articles as they are conveyed through the tunnel;
one or more nozzles arranged to deliver a gaseous mixture comprising a second set of chemicals including one or more second coating materials or precursors thereof, in a jet which traverses the path of the articles as they are conveyed through the tunnel;
at least one exit aperture through which excess gas may exit,
**characterized by** means for providing a curtain of flowing gas between said nozzles arranged to deliver the first set of chemicals and said nozzles arranged to deliver the second set of chemicals and through which the glass articles pass during transit.

2. Apparatus according to claim 1, wherein the means for providing a curtain of flowing gas comprises at least one linear inlet aperture arranged on a sidewall, each such aperture being connected to a source of compressed gas and comprising
a linear exhaust aperture arranged on the opposite sidewall to the linear inlet aperture and aligned therewith, the linear exhaust aperture being connected to means for applying a negative pressure thereto.

## Patentansprüche

1. Vorrichtung zum Beschichten von dreidimensionalen Glasgegenständen, die umfasst:
einen Tunnel, der eine obere Abdeckung und eine erste und eine zweite Seitenwand aufweist, der dafür geeignet ist, auf einem Förderband angeordnet zu werden, das die Gegenstände durch den Tunnel transportiert;
eine oder mehrere Düsen, die dafür angeordnet sind, ein gasförmiges Gemisch, das einen ersten Satz von Chemikalien umfasst, die ein oder mehrere erste Beschichtungsmaterialien oder Vorläufer davon einschließen, in einen Strahl zu liefern, der den Weg der Gegenstände durchquert, wie sie durch den Tunnel gefördert werden;
eine oder mehrere Düsen, die dafür angeordnet sind, ein gasförmiges Gemisch, das einen zweiten Satz von Chemikalien umfasst, die ein oder mehrere zweite Beschichtungsmaterialien oder Vorläufer davon einschließen, in einen Strahl zu liefern, der den Weg der Gegenstände durchquert, wie sie durch den Tunnel gefördert werden;
mindestens eine Auslassöffnung, durch die überschüssiges Gas entweichen kann,
**gekennzeichnet durch** ein Mittel zum Bereitstellen eines Vorhangs aus strömendem Gas zwischen den Düsen, die dafür angeordnet sind, den ersten Satz von Chemikalien zu liefern, und den Düsen, die dafür angeordnet sind, den zweiten Satz von Chemikalien zu liefern, und durch den die Glasgegenstände während der Durchfuhr hindurchgehen.

2. Vorrichtung nach Anspruch 1, wobei das Mittel zum Bereitstellen eines Vorhangs aus strömendem Gas mindestens eine lineare Einlassöffnung umfasst, die auf einer Seitenwand angeordnet ist, wobei jede derartige Öffnung mit einer Quelle für komprimiertes Gas verbunden ist und umfassend eine lineare Auslassöffnung, die auf der der linearen Einlassöffnung gegenüberliegenden Seitenwand angeordnet ist und mit dieser ausgerichtet ist, wobei die lineare Auslassöffnung mit einem Mittel zum Anlegen eines negativen Drucks daran verbunden ist.

## Revendications

1. Appareil pour recouvrir des articles en verre tridimensionnels comprenant :
un tunnel ayant une partie supérieure et des première et seconde parois latérales appropriées pour s'agencer sur une courroie transporteuse qui transporte les articles à travers ledit tunnel ;
une ou plusieurs buses agencées pour distribuer un mélange gazeux comprenant un premier ensemble de produits chimiques comprenant un ou plusieurs premiers matériaux de revêtement ou leurs précurseurs, dans un jet qui traverse la trajectoire des articles lorsqu'ils sont transportés à travers le tunnel ;
une ou plusieurs buses agencées pour distribuer un mélange gazeux comprenant un second ensemble de produits chimiques comprenant un ou plusieurs seconds matériaux de revêtement ou leurs précurseurs, dans un jet qui traverse la trajectoire des articles lorsqu'ils sont transportés à travers le tunnel ;
au moins une ouverture à travers laquelle le gaz en excès peut sortir,
**caractérisé par** un moyen pour fournir un rideau de gaz d'écoulement entre lesdites buses agencées pour distribuer le premier ensemble de produits chimiques et lesdites buses agencées pour distribuer le second ensemble de produits chimiques et à travers lequel les articles en verre passent pendant le transit.

2. Appareil selon la revendication 1, dans lequel le moyen pour fournir un rideau de gaz d'écoulement comprend au moins une ouverture d'entrée linéaire agencée sur une paroi latérale, chacune de ces ouvertures étant raccordée à une source de gaz comprimé et comprenant :
une ouverture d'échappement linéaire agencée sur la paroi latérale opposée à l'ouverture d'entrée linéaire et alignée avec cette dernière, l'ouverture d'échappement linéaire étant raccordée au moyen pour y appliquer une pression négative.
